# EUROPEAN PATENT APPLICATION

(11) **EP 0 809 115 A2**
(43) Date of publication of application: **26.11.1997**
(21) Application number: 97201497.1
(22) Date of filing: 19.05.1997
(51) Int. Cl.: G01R 15/16

(54) **Voltage measuring instrument and voltage measuring method using the same**

(30) Priority: 23.05.1996 JP 153205/96
(71) Applicant: Yamamoto, Makoto, Nagano (JP)
(72) Inventor: Yamamoto, Makoto, Ina, Nagano (JP); Karasawa, Isao, Matsumoto, Nagano (JP)
(74) Representative: Falcetti, Carlo

(57) **Abstract**

The invention relates to a voltage measuring instrument and a voltage measuring method using the same. One end of the core conductor 12 of a voltage measuring instrument 10 is connected to each of the primary side receiving terminals of a transformer, and a cable for supplying power is connected to the other end of the respective core conductor 12. An amplifier 24 having a voltmeter 22 connected thereto is connected between the outer circumferential conductors 16, 16 of the voltage measuring instrument 10,10 making a pair. When the primary voltage is applied to the core conductor 12 connected to each cable, microvoltage appears in the outer circumferential conductor 16 due to electrostatic capacity between the core conductor 12 and outer circumferential conductor 16. The microvoltage is amplified by an amplifier 24 and the voltage obtained is displayed on a voltmeter 22, whereby the primary side voltage of a single phase transformer can be measured.

## Description

### BACKGROUND OF THE INVENTION

### Field of the invention

The present invention relates to a voltage measuring instrument or probe for measuring the voltage at the primary and secondary sides of a transformer for, for example, power distribution, and a voltage measuring method using the same.

### Description of the related art

Inside a cubicle disposed in a power substation, current transformers for measuring electric currents, voltage transformers for instruments for measuring voltage, circuit breakers, etc. are disposed at an appointed arrangement centering around a transformer for power distribution, and the respective devices are connected with cables. A voltage transformer for instruments for measuring voltage is identical to a general transformer in the basic construction. Low voltage which is completely insulated from the high voltage applied at the primary side is led out to the secondary side, and the low voltage is measured by a voltmeter connected to the secondary side. The primary side voltage is calculated from the voltage measured at the secondary side.

Since said transformer for instruments has the same construction as that of a general transformer and high voltage is applied to the primary side thereof, there is a fear that such an accident may occur, where a worker touches the high voltage parts by mistake and is struck by an electricity when carrying out a maintenance, inspection and cleaning work at the substation facilities consisting of general transformers, current transformers, transformers for instruments, etc.

Furthermore, there are many cases where insects and/or rats enter inside a cubicle, and said insects and/or rats touch the exposed high voltage parts and are struck by en electricity, whereby such a problem occur, which results in a deterioration or damage of said transformers for instruments. Still furthermore, there is a shortcoming by which the entire facility will be large-sized since the inner space of the cubicle can not be effectively utilized due to said transformers for instruments being large in size. Moreover, an unfavorable point is pointed out, which high production cost of the entire facility is required since transformers for instruments are expensive.

### SUMMARY OF THE INVENTION

In view of the problematic points and shortcomings inherently existing in the prior art described above, the present invention was developed to preferably solve them. It is therefore an object of the invention to provide a voltage measuring instrument and a voltage measuring method using the same, which are able to prevent an electric shock accident from occurring and are able to achieve a down sizing and to decease the production cost thereof.

In order to overcome the problems and shortcomings and achieve the object, a voltage measuring instrument according to the invention comprises a core conductor electrically connected to a cable, an insulator coated at an appointed thickness onto said core conductor, and a circumferential conductor wound on the outer circumference of said insulator, wherein microvoltage appearing in said circumferential conductor by electrostatic capacity between said core conductor and circumferential conductor is able to be measured, (e.g by capacitive coupling).

In order to achieve the abovementioned object, a voltage measuring method according to another invention of the present application comprises attaching a voltage measuring instrument defined in claim 1 to each of a pair of cable, amplifying the microvoltage appearing in the circumferential conductor of said voltage measuring instrument by using an amplifier connected to the circumferential conductor at said pair of voltage measuring instrument, and displaying the voltage amplified by said amplifier on a display connected to said amplifier.

In order to achieve the abovementioned object, a voltage measuring method according to still another invention of the present application comprises connecting a core conductor according to a voltage measuring instrument defined in claim 1 in series between each terminal of the primary side or the secondary side of a transformer for power distribution and a cable to be connected to said each terminal, amplifying microvoltage appearing in the circumferential conductor of said voltage measuring instrument by an amplifier connected to the circumferential conductors which make a pair at the primary side or the secondary side of said transformer and exist at the voltage measuring instrument, and displaying the voltage amplified by said amplifier on a display connected to said amplifier.

### BRIEF DESCRIPTION OF THE DRAWINGS

Fig. 1 is a perspective view showing the brief construction of a voltage measuring instrument according to a preferred embodiment of the invention.

Fig.2 is a cross-sectional view for explaining a voltage measuring instruction according to the preferred embodiment.

Fig.3 is an explanatory view showing a state where the voltage measuring instrument is connected to a receiving terminal at the primary side of a single phase transformer and a cable.

Fig.4 is an explanatory view briefly showing a measuring method in a case of measuring the primary side voltage of a single phase transformer.

Fig.5 is an explanatory view showing a state where the voltage measuring instrument is connected to a receiving terminal at the primary side of a three-phase transformer and a cable.

Fig.6 is an explanatory view briefly showing a measuring method in a case of measuring the primary side voltage of a three-phase transformer.

### DETAILED DESCRIPTION OF PREFERRED EMBODIMENT

A description will be given of a preferred embodiment of a voltage measuring instrument and a voltage measuring method according to the invention, with reference to the accompanying drawings.

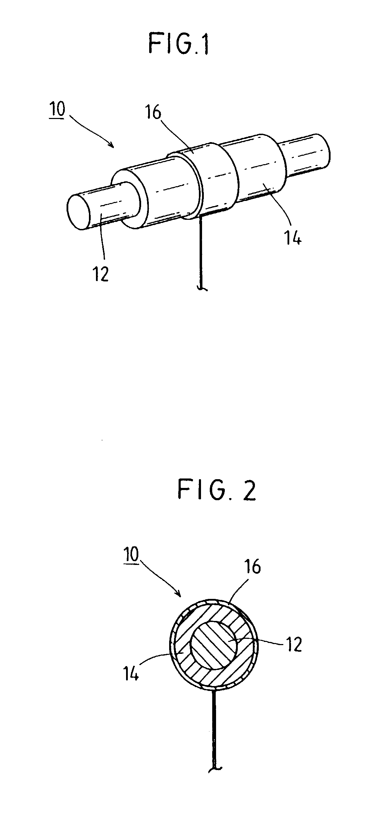

Fig. 1 and Fig.2 are a perspective view showing the outline of a voltage measuring instrument according to the preferred embodiment, wherein said measuring instrument 10 is constructed so that an insulator 14 is coated at an appointed thickness on the outer circumference of a core conductor 12 having an appointed length, and a sleeve-like outer circumferential conductor 16 of an appointed dimension is wound onto the insulator 14. And it is constructed so that microvoltage can appear in the outer circumferential conductor 12 due to electrostatic capacity between the core conductor 12 and outer circumferential conductor 16 by applying appointed voltage to the core conductor 12. Furthermore, for example, synthetic resin such as epoxi, polyester, etc. and synthetic rubber such as butyl rubber, ethylene/propylene rubber, etc. may be preferably used as a material of the insulator 14.

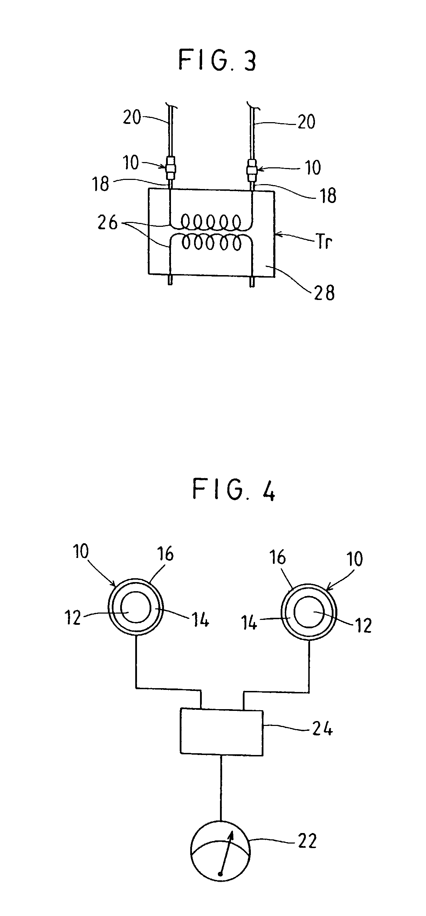

Fig.3 and Fig.4 briefly show a measuring method in a case of measuring the primary side voltage of a single phase transformer Tr for power distribution by using the voltage measuring instrument 10, wherein one end of a pair of core conductors 12 in the voltage measuring instrument 10 is connected to the primary side receiving terminals 18,18 of the transformer Tr. Cables 20 are respectively connected to the other end of the respective core conductors 12. An amplifier 24 to which a voltmeter 22 used as a display is connected is connected between the outer circumferential conductors 16,16 of the voltage measuring instruments 10 making a pair.

With the abovementioned construction, when the primary voltage is given to the core conductor 12 connected to each cable 20, microvoltage appears in the outer circumferential conductor 16 due to electrostatic capacity between the core conductor 12 and outer circumferential conductor 16. The microvoltage is amplified by the amplifier 24. By displaying the obtained voltage on the voltmeter 22, the primary side voltage of the single phase transformer Tr can be measured. Herein, an analog type or digital type voltmeter may be selectively used as a voltmeter 22. It is also possible to measure the secondary side voltage of the single phase transformer Tr with the same construction.

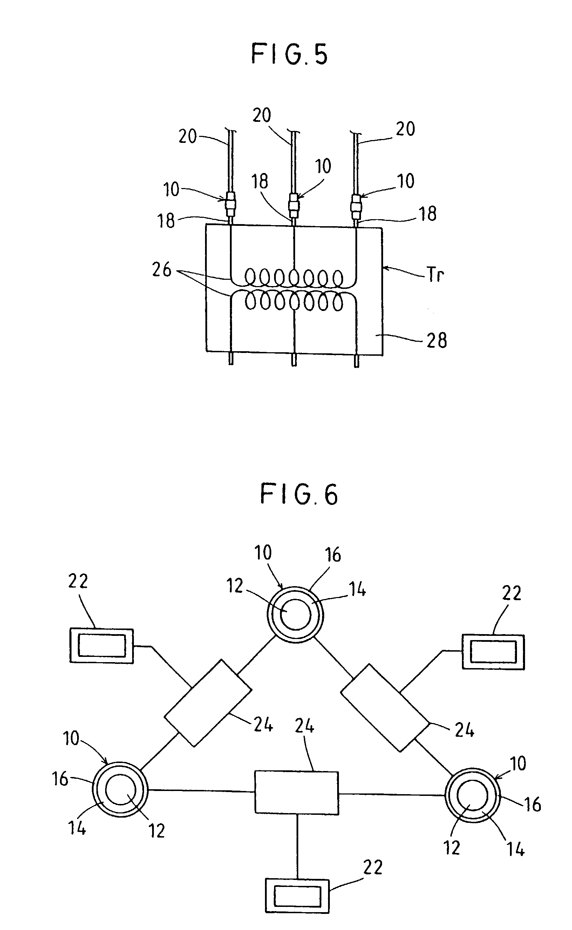

Fig.5 and Fig.6 briefly show a measuring method in a case of measuring the primary side voltage of a three-phase transformer Tr for power distribution by using the voltage measuring instrument 10, wherein a voltage measuring instrument 10 is caused to intervene, by connecting the core conductor 12 thereof in series, between the primary side receiving terminals 18,18,18 of the transformer Tr and power supplying cables 20,20,20 to be connected to the respective receiving terminals 18,18,18. By connecting an amplifier 24, to which a voltmeter 24 is connected, between the outer circumferential conductors 16,16 of voltage measuring instruments making a pair, it is possible to measure the voltage.

In the abovementioned preferred embodiment, since it is devised that the voltage known on the basis of the microvoltage appearing due to electrostatic capacity of the voltage measuring instrument 10 is measured, no high voltage is produced at any exposed parts, and it is possible to prevent an electric shock accident from occurring and to nip in the bud the deterioration and/or damage of a voltage measuring instrument 10 due to electric shocks of insects and/or rats. Furthermore, since the voltage measuring instrument 10 is simple in construction, the production cost thereof is remarkably suppressed, and a remarkable down sizing can be achieved. Therefore, it is very advantageous in view of reducing the installation space thereof. Still furthermore, in a case where the abovementioned transformer Tr is constructed and unitized so that an insulation molding material 28 is filled around the coil 26 thereof and no high voltage part is exposed, it is also possible to prevent an electric shock accident resulting from the transformer Tr from occurring. As in the abovementioned insulator 14, for example, synthetic resin such as epoxi, polyester, etc. and synthetic rubber such as butyl rubber, ethylene/propylene rubber, etc. may be preferably used as this insulation molding material 28.

Herein, by changing the thickness of the abovementioned insulator 14 and the length of the outer circumferential conductor 16 in line with the level of the voltage to be measured, it is possible to vary the electrostatic capacity between the core conductor 12 and outer circumferential conductor 16. That is, the microvoltage appearing in the outer circumferential conductor 16 is adjusted and is alway set to a safe value, whereby it is possible to securely prevent an electric shock accident from occurring. In the preferred embodiment, a description was given of a case of measuring the primary side voltage or the secondary side voltage of a transformer Tr. However, the invention is not limited to this case. For example, a voltage measuring instrument can be connected to a circuit breaker to be connected to a transformer and can be employed in various devices for which it is necessary to measure the voltage. It is highly recommended that in order to prevent the electrostatic capacity of the voltage measuring instrument from fluctuating due to a change of the temperature of the surroundings, the abovementioned outer circumferential conductor is coated with a humidity resisting paint or covered with a humidity resisting material. Furthermore, the outer circumferential conductor itself may be composed of a material having a humidity resisting property. Still furthermore, the entirety of a voltage measuring instrument may be coated with an insulating material with only the terminal connected to the outer circumferential conductor exposed to the outside of the insulating material, whereby the terminal may be connected to an amplifier.

## Claims

1. A voltage measuring instrument comprising:
a core conductor (12) electrically connected to a cable (20);
an insulator (14) coated at an appointed thickness on the outside of said core conductor; and
an outer circumferential conductor (16) wound and applied onto the outer circumference of said insulator (14),
wherein microvoltage appearing in said outer circumferential conductor (16) is measured by electrostatic capacity between said core conductor (12) and outer circumferential conductor (16).

2. A voltage measuring method comprising:
causing a voltage measuring instrument (10) defined in claim 1 to intervene between a pair of cables (20,20);
amplifying microvoltage appearing in the outer circumferential conductor (16,16) of said voltage measuring instrument (10,10) by using an amplifier (24) connected to the outer circumferential conductor (16,16) in said pair of voltage measuring instruments (10); and
displaying the voltage amplified by said amplifier (24) on a display (22) connected to said amplifier (24).

3. A voltage measuring method comprising:
connecting a core conductor (12) in a voltage measuring instrument (10) defined in claim 1 in series between each terminal (18) of the primary side or secondary side of a transformer (Tr) for power distribution and a cable (20) to be connected to said each terminal;
amplifying microvoltage appearing in the outer circumferential conductor (16,16) of said voltage measuring instrument (10,10) by an amplifier (24) connected to the outer circumferential conductor (16,16) in voltage measuring instruments (10,10) making a pair at the primary side or secondary side of said transformer (Tr); and
displaying the voltage amplified by said amplifier (24) on a display (22) connected to said amplifier (24).

4. A probe for measuring, by capacitive coupling, the voltage between two elecrical cables (20) coupled to the primary or secondary side of a transformer, by comprising a core conductor (12) for electrical connection to one of said cables (12),
an insulator (14) coated at an appointed thickness on the outside of said core conductor, and
an outer circumferential conductor (16) wound and applied onto the outer circumference of said insulator (14), whereby, by connecting the core conductor of two of said probes to said cables (20) and by connecting the outer circumferential conductor (16) of said probes to a voltage measuring instrument, a capacitive coupling is established between said voltage measuring instrument and said cables and a voltage related to the voltage between said cables (20) is developed at the input of said voltage measuring instrument and can be measured.
